# EUROPÄISCHE PATENTSCHRIFT

(11) **EP 0 852 700 B1**
(45) Veröffentlichungstag und Bekanntmachung des Hinweises auf die Patenterteilung: **03.07.2002**
(21) Anmeldenummer: 96941573.6
(22) Anmeldetag: 13.09.1996
(51) Int. Cl.: G01D 5/16, G01R 33/09

(54) **VORRICHTUNG ZUR BERÜHRUNGSLOSEN POSITIONSERFASSUNG EINES OBJEKTES UND VERWENDUNG DER VORRICHTUNG**
DEVICE FOR DETERMINING AN OBJECT'S POSITION WITHOUT CONTACT AND USE OF THE DEVICE
SYSTEME DE DETECTION SANS CONTACT DE LA POSITION D'UN OBJET ET UTILISATION DUDIT DISPOSITIF

(30) Priorität: 29.09.1995 DE 19536433
(43) Veröffentlichungstag der Anmeldung: 15.07.1998
(73) Patentinhaber: SIEMENS AKTIENGESELLSCHAFT, 80333 München (DE)
(72) Erfinder: SCHELTER, Wolfgang, D-91080 Uttenreuth (DE); CLEMENS, Wolfgang, D-90617 Puschendorf (DE); SCHMIDT, Ludwig, D-80637 München (DE); VIETH, Michael, D-91096 Möhrendorf (DE)
(86) Internationale Anmeldenummer: DE9601729
(87) Internationale Veröffentlichungsnummer: WO9713120

(56) Entgegenhaltungen:
- WO-A-94/17426
- WO-A-95/10020
- DE-A- 2 532 985
- DE-A- 3 308 404
- DE-A- 3 526 338
- DE-A- 4 411 808

## Beschreibung

Die Erfindung bezieht sich auf eine Vorrichtung zur berührungslosen Erfassung der Position eines Objektes bezüglich einer vorgegebenen Ausgangslage. Die Vorrichtung umfaßt dabei eine magnetfelderzeugende Einrichtung und eine Sensoreinrichtung. Die magnetfelderzeugende Einrichtung bildet an einer gedachten Bezugslinie einen Magnetpol oder längs der Linie mehrere hintereinandergereihte, wechselnde Magnetfeldrichtungen erzeugende Magnetpole. Die Sensoreinrichtung enthält wenigstens einen stromdurchflossenen, einen GMR-Effekt zeigenden Sensor, der ein Schichtensystem mit mindestens einer magnetisch weichen Meßschicht mit einer in ihrer Schichtebene drehbaren Magnetisierung und mindestens einen magnetisch härteren Biasteil mit einer zumindest weitgehend unveränderten Magnetisierung aufweist. Mit dieser Sensoreinrichtung oder mit der magnetfelderzeugenden Einrichtung ist das Objekt starr verbunden. Außerdem ist die magnetfelderzeugende Einrichtung bezüglich der Sensoreinrichtung
i) so angeordnet, daß die Richtung einer Normalen auf der Ebene der Meßschicht des wenigstens einen Sensors unter einem von Null verschiedenen Winkel ϕ bezüglich der gedachten Bezugslinie des mindestens einen Magnetpols verläuft,
   und
ii) so relativ zu bewegen, daß dabei das Magnetfeld des mindestens einen Magnetpols von der Meßschicht des wenigstens einen Sensors erfaßt wird und daß dabei ein der Zahl der erfaßten Magnetpole entsprechend vielfaches Durchlaufen der Sensorkennlinie oder eines Teils derselben bewirkt wird.

Die Erfindung betrifft ferner die Verwendung einer solchen Vorrichtung. Eine entsprechende Vorrichtung und deren Verwendung sind der WO-A-94/17426 zu entnehmen.

In Schichten aus ferromagnetischen Übergangsmetallen wie Ni, Fe oder Co und deren Legierungen kann eine Abhängigkeit des elektrischen Widerstandes von der Größe und der Richtung eines das Material durchdringenden Magnetfeldes gegeben sein. Den bei solchen. Schichten auftretenden Effekt nennt man "anisotropen Magnetowiderstand (AMR)" oder "anisotropen magnetoresistiven Effekt". Er beruht physikalisch auf den unterschiedlichen Streuquerschnitten von Elektronen mit unterschiedlichem Spin und der Spinpolarität des D-Bandes. Die Elektronen werden als Majoritäts- bzw. Minoritätselektronen bezeichnet. Für entsprechende magnetoresistive Sensoren wird im allgemeinen eine dünne Schicht aus einem solchen magnetoresistiven Material mit einer Magnetisierung in der Schichtebene vorgesehen. Die Widerstandsänderung bei Drehung der Magnetisierung bezüglich der Richtung eines über den Sensor geleiteten Stromes kann dann einige Prozent des normalen isotropen (= ohm'schen) Widerstandes betragen.

Aus der DE-A-33 08 404 ist eine Vorrichtung zur Erfassung bzw. Messung einer Relativverschiebung zu entnehmen, die eine magnetfelderzeugende Einrichtung in Form eines magnetischen Aufzeichnungsträgers mit wenigstens einer Magnetspur enthält. Zum Auslesen dieser Spur ist eine Sensoreinrichtung vorgesehen, die mehrere Sensoren in Form von vormagnetisierten Magnetowiderstandselementen umfaßt. Diese Elemente zeigen einen AMR-Effekt und können so angeordnet sein, daß sie mit ihrer Flachseite dem Aufzeichnungsträger zugewandt sind.

Aus der DE-A-35 26 338 geht eine Meßeinrichtung mit magnetoresistiven Elementen hervor, die ebenfalls einen AMR-Effekt zeigen. Die magnetoresistiven Elemente sind einer magnetischen Maßeinteilung beispielsweise auf dem Umfang eines zylindrischen Körpers mit alternierenden Magnetpolen gegenüber angeordnet.

Die DE-A-25 32 985 offenbart eine Vorrichtung zur Ermittlung der Richtung eines Magnetfeldes mit mehreren, ebenfalls einen AMR-Effekt zeigenden magnetoresistiven Elementen. Die Elemente sind dabei in einer gemeinsamen Ebene an einem scheibenförmigen Vormagnetisierungsmagneten so angeordnet, daß sie und ihre Vormagnetisierungsrichtungen vorbestimmte Winkel einschließen.

Ferner sind seit einiger Zeit magnetoresistive Mehrschichtensysteme bekannt, welche mehrere, zu einem Stapel angeordnete ferromagnetische Schichten enthalten, die jeweils durch metallische Zwischenschichten voneinander getrennt sind und deren Magnetisierungen jeweils in der Schichtebene liegen. Die Dicken der einzelnen Schichten sind dabei deutlich geringer als die mittlere freie Weglänge der Leitungselektronen gewählt. In solchen Mehrschichtensystemen kann nun zusätzlich zu dem erwähnten anisotropen magnetoresistiven Effekt AMR ein sogenannter "giant-magnetoresistiver Effekt" oder "Giant-Magnetowiderstand (GMR)" auftreten (vgl. z.B. EP-A-0 483 373). Ein solcher GMR-Effekt beruht auf der unterschiedlich starken Streuung von Majoritäts- und Minoritäts-Leitungselektronen an den Grenzflächen zwischen den ferromagnetischen Schichten und den dazu benachbarten Schichten sowie auf Streueffekten innerhalb dieser Schichten, insbesondere bei Verwendung von Legierungen. Der GMR-Effekt ist dabei ein isotroper Effekt. Er kann erheblich größer sein als der anisotrope Effekt AMR. In entsprechenden, einen GMR-Effekt zeigenden Mehrschichtensystemen sind benachbarte metallische Schichten zunächst entgegengesetzt magnetisiert, wobei eine Biasschicht bzw. ein Biasschichtteil magnetisch härter als eine Meßschicht ist. Unter Einfluß eines äußeren Magnetfeldes, d.h. einer in der Schichtebene ausgeprägten Komponente dieses Feldes, kann sich dann die anfängliche antiparallele Ausrichtung der Magnetisierungen in eine parallele umwandeln. Bei entsprechenden Magnetfeldsensoren wird diese Tatsache ausgenutzt.

Ein entsprechender Sensor geht aus der eingangs genannten WO-A-Schrift hervor. Er ist Teil einer Vorrichtung zur berührungslosen Erfassung einer Winkelposition eines Objektes. Hierzu ist das Objekt starr mit einem Permanentmagneten verbunden, der in einer zu einer Meßschichtebene parallelen Ebene drehbar angeordnet ist. Dieser Magnet erzeugt in der Meßschicht eine Magnetfeldkomponente, die somit gegenüber einer magnetischen Vorzugsachse eines Biasteils des Sensors drehbar ist und deshalb zu einer entsprechenden Drehung der Magnetisierung in der magnetisch weicheren Meßschicht führt. Der elektrische Widerstand des Sensors hängt so vom Winkel zwischen der Magnetisierung der Meßschicht und der magnetischen Vorzugsrichtung des Biasteils ab. Diese Abhängigkeit ist im allgemeinen anisotrop aufgrund der vorgegebenen Form (Geometrie) des Schichtaufbaus des Sensors. Eine entsprechende Vorrichtung zum Erfassen einer Winkelposition, die insbesondere ein kontaktloses Potentiometer bilden kann, ist jedoch eingeschränkt auf eine gemeinsame Symmetrieachse des Magneten und des Sensors, um welche entweder der Magnet oder der Sensor selbst drehbar angeordnet ist.

Aufgabe der vorliegenden Erfindung ist es, die bekannte Vorrichtung mit den eingangs genannten Merkmalen dahingehend auszugestalten, daß eine derartige Einschränkung nicht mehr gegeben ist.

Diese Aufgabe wird erfindungsgemäß mit den in Anspruch 1 aufgeführten Maßnahmen gelöst. Dabei soll die magnetfelderzeugende Einrichtung bezüglich der Sensoreinrichtung derart angeordnet sein, daß der mindestens eine Magnetpol der magnetfelderzeugenden Einrichtung mit seiner Polfläche der Meßschicht des wenigstens einen Sensors zugewandt ist.

Die mit dieser Ausgestaltung der Positionserfassungsvorrichtung verbundenen Vorteile sind insbesondere darin zu sehen, daß zum einen eine kontaktlose Erfassung von Winkelpositionen von Objekten im gesamten Winkelbereich von 360° oder von Linearpositionen zu realisieren ist und daß zum anderen die Anforderungen an die erforderliche Genauigkeit der Montagepositionen der magnetfelderzeugenden Einrichtung und der Sensoreinrichtungen vermindert sind. Denn mit der Verwendung von mindestens einem Sensor für die Sensoreinrichtung, der ein Schichtensystem mit erhöhtem magnetoresistiven Effekt aufweist, wird hier bei einem Vorbeiführen des mindestens einen Magnetpols an der Sensoreinrichtung auf der Bezugslinie im wesentlichen nur die Abhängigkeit des Sensormeßsignals von der Richtung des äußeren Magnetfeldes, nicht aber von dessen Feldstärke ausgenutzt.

Besonders vorteilhaft ermöglicht eine solche Positionserfassungsvorrichtung den Aufbau eines kontaktlosen Potentiometers.

Vorteilhafte Ausgestaltungen der erfindungsgemäßen Positionserfassungsvorrichtung gehen aus den abhängigen Ansprüchen hervor.

Zur weiteren Erläuterung der Erfindung wird nachfolgend auf die Zeichnung Bezug genommen. Es zeigen jeweils schematisch
- die Figuren 1 und 2: in Seiten- bzw. Aufsicht eine erste Ausführungsform einer erfindungsgemäßen Drehpositionserfassungsvorrichtung mit einem Polrad,
- die Figuren 3 und 4: in Seitenaufsicht eine zweite bzw. eine dritte Ausführungsform einer entsprechenden Vorrichtung,
- die Figur 5: in Seitenansicht eine Ausführungsform einer erfindungsgemäßen Linearpositionserfassungsvorrichtung mit einer linearen Polanordnung,
- die Figur 6: in Seitenansicht eine vierte Ausführungsform einer erfindungsgemäßen Drehpositionserfassungsvorrichtung mit einem Polrad,
- die Figur 7: eine Aufsicht auf die Vorrichtung nach Figur 6
und
- die Figur 8: in Seitenansicht eine fünfte Ausführungsform einer erfindungsgemäßen Drehpositionserfassungsvorrichtung mit einem anderen Polrad.

In den Figuren sind sich entsprechende Teile mit denselben Bezugszeichen versehen.

Mit einer erfindungsgemäßen Vorrichtung ist eine lineare Position oder eine Drehposition eines beliebigen Objektes berührungslos zu erfassen. Die Vorrichtung weist zwei Haupteinheiten auf, nämlich eine Einrichtung zur Erzeugung einer magnetischen Feldkomponente sowie eine Einrichtung zur Detektion dieser Magnetfeldkomponente, um ein im wesentlichen nur von der Magnetfeldrichtung abhängiges Ausgangssignal zu erzeugen. Eine dieser beiden Einrichtungen ist starr mit dem Objekt verbunden, so daß dessen Position bezüglich einer vorgegebenen Ausgangslage bzw. relativ zu der Position der anderen Einrichtung zu erfassen ist. Die magnetfelderzeugende Einrichtung weist einen oder mehrere an der Detektionseinrichtung ein- oder mehrmals vorbeizuführende und dieser zugewandte Magnetpole auf. Ist nur ein Magnetpol vorgesehen, so kann dieser an einer gedachten Bezugslinie liegend angesehen werden. Bei mehreren Magnetpolen sollen diese längs einer entsprechenden gedachten Bezugslinie gesehen hintereinandergereiht sein, wobei die von den Magnetpolen erzeugten Magnetfelder längs dieser Linie wechselnde, vorzugsweise alternierende oder periodisch wechselnde Magnetfeldrichtungen bezüglich der Detektionseinrichtung haben sollen. Die Bezugslinie kann dabei eine gerade oder eine gekrümmte Linie darstellen. Im Falle einer Geraden ist insbesondere eine Erfassung einer Linearposition eines Objektes möglich. Mit einer gekrümmten Linie kann insbesondere eine Umfangslinie eines Kreises ausgebildet sein, wie er z.B. von einem Polrad gebildet wird.

Damit lassen sich vorzugsweise Winkelpositionen zwischen 0 und 360° erfassen. Die als Sensoreinrichtung anzusehende bzgl. der Magnetfeldrichtung empfindliche Einrichtung umfaßt mindestens einen stromdurchflossenen Sensor. Dabei können mehrere sich entsprechende Sensoren zu der Sensoreinrichtung elektrisch verschaltet sein und beispielsweise eine Wheatstone'sche Brücke bilden. Jeder Sensor weist ein Mehrschichtensystem auf, das einen erhöhten magnetoresistiven Effekt, insbesondere einen sogenannten GMR-Effekt, zeigt. Das Schichtensystem enthält deshalb mindestens eine magnetisch weichere Meßschicht mit einer in ihrer Schichtebene drehbaren Magnetisierung. Parallel dazu ist ein Biasteil mit einer Biasschicht oder einem Biasschichtensystem angeordnet, wobei der Biasteil magnetisch härter und unter dem Einfluß des Magnetfeldes des mindestens einen Magnetpoles eine zumindest weitgehend unveränderte Magnetisierung besitzt. Entsprechende Mehrschichtensysteme mit GMR-Effekt sind z.B. aus den Schriften EP-A-0 483 373, DE-A-42 32 244, DE-A-42 43 357 oder DE-A-42 43 358 bekannt.

Bei einer Positionserfassungsvorrichtung mit diesen Merkmalen soll erfindungsgemäß deren magnetfelderzeugende Einrichtung bezüglich der Sensoreinrichtung in vorbestimmter Weise angeordnet sein:
Hierzu werden eine Normale auf der Ebene der Meßschicht des Mehrschichtensystems des mindestens einen Sensors sowie die gedachte Bezugslinie , an welcher der mindestens eine Magnetpol der magnetfelderzeugenden Einrichtung liegt, betrachtet. Dann soll die Normalenrichtung mit der Bezugslinie an deren der Meßschicht nähesten Stelle einen Winkel einschließen, der von Null verschieden ist. Vorzugsweise ist dieser Winkel zumindest annähernd 90°. Die Bezugslinie liegt dann in einer Ebene, die zumindest annähernd parallel zur Ebene der Meßschicht verläuft.
Außerdem sollen die magnetfelderzeugende Einrichtung und die Sensoreinrichtung relativ zueinander so zu bewegen sein, daß dabei das Magnetfeld des mindestens einen Magnetpols der magnetfelderzeugenden Einrichtung von der Meßschicht des Mehrschichtensystems des wenigstens einen Sensors erfaßt wird und bei der Führung des mindestens einen Magnetpols durch den Erfassungsbereich der Sensoreinrichtung ein der Anzahl der vorhandenen bzw. erfaßten Magnetpole entsprechend vielfaches Durchlaufen der Sensorkennlinie oder eines Teils derselben bewirkt wird. Als Sensorkennlinie werden dabei die in einem Diagramm darstellbaren Widerstandswerte angesehen, die die Sensoreinrichtung bei einem Vorbeiführen eines Magnetpols an ihrer mindestens einen Meßschicht annehmen kann.

Selbstverständlich ist es auch möglich, daß die Magnetpole der magnetfelderzeugenden Einrichtung auch wiederholt durch den Erfassungsbereich der Sensoreinrichtung geführt werden (oder umgekehrt). Dann wird die Sensorkennlinie oder deren Teillinie entsprechend der Anzahl an von der Sensoreinrichtung insgesamt nacheinander erfaßten Magnetpolen oft durchlaufen.

Einige Ausführungsbeispiele entsprechender erfindungsgemäßer Dreh- und Linearpositionserfassungseinrichtungen sind aus den Figuren ersichtlich. Dort nicht näher dargestellte Teile sind allgemein bekannt, so daß auf deren Beschreibung nachfolgend verzichtet ist.

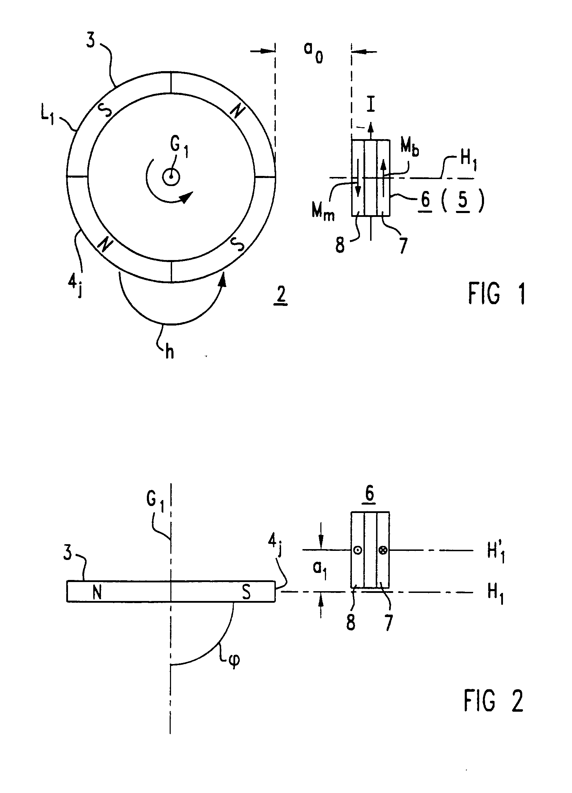

Gemäß der in den Figuren 1 und 2 angedeuteten Ausführungsform einer entsprechenden Vorrichtung 2 zur Erfassung einer Drehposition ist deren magnetfelderzeugende Einrichtung als ein magnetisches Polrad 3 gestaltet. Das Polrad ist um eine Bezugsachse G₁ drehbar gelagert und beispielsweise auf der Achse eines Elektromotors montiert. Es enthält auf einer längs seines Außenumfangs verlaufenden Bezugslinie L₁ in Umfangsrichtung gesehen hintereinanderliegende Magnetpole 4ⱼ mit wechselnder Polarität. Von den n (mit 1 ≤ j ≤ n) Magnetpolen sind in der Figur nur vier gezeigt, zwei mit Polarität N (= Nordpol) und zwei mit Polarität S (= Südpol). Das zwischen benachbarten Polen mit unterschiedlicher Polarität verlaufende Magnetfeld ist durch eine Feldlinie h angedeutet.

Das Polrad 3 ist in einem Abstand a₀ seiner Bezugslinie L₁ von dem Sensor 6 einer Sensoreinrichtung 5 entfernt angeordnet. Der in den Figuren gegenüber dem Polrad nicht maßstäblich dargestellte Sensor wird von einem Strom I durchflossen und weist ein Mehrschichtensystem mit einem in seiner Magnetisierung M_{b} festen Schichtteil 7, einem sogenannten Biasteil, und einer weichmagnetischen Meßschicht 8 mit einer in der Schichtebene drehbaren Magnetisierung Mₘ auf. Eine Normale auf der Oberflächenebene des Schichtpaketes des Mehrschichtensystems des Sensors 6 bzw. der Meßschicht 8 sei mit H₁ bezeichnet.

Erfindungsgemäß ist der Sensor 6 bezüglich des Polrades 3 so angeordnet, daß die Bezugsachse G₁ (= Drehachse) des Polrades nicht parallel zur Normalen H₁ auf der Sensorebene verläuft. Wie aus den Figuren 1 und 2 hervorgeht, schließen die Bezugsachse G₁ und die Normale H₁ einen Winkel ϕ mit einem Wert ungleich Null, vorzugsweise einen Winkel ϕ von zumindest annähernd 90° ein. Dann sind bei einer Drehung des Polrades 3 um die Bezugsachse G₁ die Magnetpole 4ⱼ mit ihren Polflächen nacheinander dem Sensor 6 direkt zugewandt.

Bei einer solchen Drehung wird die Widerstandskennlinie des giant-magnetoresistiven Sensors 6 n-fach durchlaufen. Da die Richtung der Magnetisierung Mₘ der weichmagnetischen Meßschicht 8 im giant-magnetoresistiven Sensor 6 in einem weiten Feldbereich dem einwirkenden Magnetfeld folgt und die Widerstandsänderung des Mehrschichtenpakets nur vom Winkel der Magnetisierungen Mₘ in der Meßschicht und M_{b} in dem Biasteil abhängt, ist das von dem Sensor abgegebene Signal, das die Winkellage des magnetischen Polrades 3 abbildet, vorteilhaft in einem weiten Bereich unabhängig von dem Abstand a₀ zwischen dem Polrad und dem Sensor.

Wie ferner aus Figur 2 entnehmbar ist, braucht die Normale H₁ nicht unbedingt die Mittelachse H₁' des Sensors 6 darstellen, sondern kann gegenüber dieser Achse auch um einen Abstand a₁ verschoben sein.

Durch die hohe Empfindlichkeit von giant-magnetoresistiven Sensoren ist bei der erfindungsgemäßen Positionserfassungsvorrichtung keine differentielle Anordnung mehr nötig, wie sie z.B. bei Hallsensoren (vgl. z.B. Datenbuch "Magnetic Sensors" der Siemens AG, 1989, Seite 57) erforderlich wird; dadurch lassen sich kleinere Polabstände eines Polrads ermöglichen, so daß dann eine entsprechend höhere Auflösung und/oder eine entsprechende Miniaturisierung erreichbar ist.

Bei der in den Figuren 1 und 2 gezeigten Drehpositionserfassungsvorrichtung 2 kann in dem zwischen dem Polrad 3 und dem Sensor 6 durch den Abstand der Größe a₀ gekennzeichneten Raum eine Trenn- oder Gehäusewand eingefügt werden. Diese Wand muß aus einem nicht-ferromagnetischen Material bestehen. Ein solcher Aufbau läßt sich insbesondere dann vorsehen, wenn beispielsweise das Polrad oder der Sensor in ein Gehäuse eingebaut oder in unterschiedlichen Umgebungsmedien, die durch eine Trennwand voneinander zu trennen sind, angeordnet werden sollen.

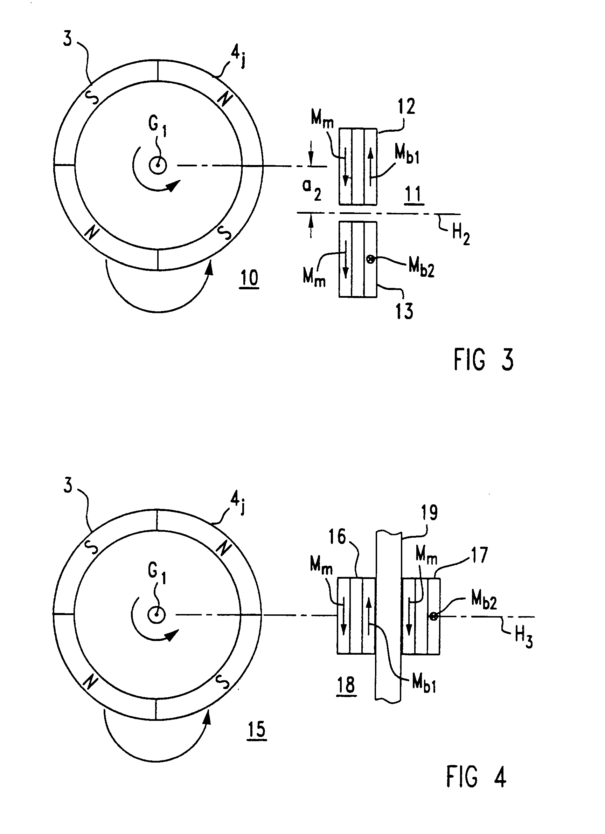

Die in Figur 3 dargestellte Ausführungsform einer Vorrichtung 10 zur Erfassung der Drehposition eines Polrades 3 (gemäß Figur 1) mit n Magnetpolen 4ⱼ weist eine Sensoreinrichtung 11 mit einem Paar von magnetoresistiven Sensoren 12 und 13 auf. In der Figur sind die Sensoren gegenüber dem Polrad nicht maßstäblich - aus Gründen der Übersichtlichkeit vergrößert - dargestellt. Sie sind elektrisch miteinander verschaltet und werden von einem Strom I durchflossen. Ihre Mehrschichtensysteme liegen in einer gemeinsamen Ebene und sind so zueinander ausgerichtet, daß die Richtungen der Magnetisierungen M_{b1} und M_{b2} ihrer Biasteile vorzugsweise rechtwinklig zueinander verlaufen. Eine den Sensoren gemeinsame Bezugsachse H₂, die in Richtung einer Normalen auf der Ebene der Sensoren weist und zentral zwischen den untereinander beabstandeten Sensoren verläuft, schließt mit der Drehachse G₁ des Polrades 3 einen Winkel von 90° ein. Gegenüber dieser Drehachse ist die Bezugsachse H₂ um einen Abstand a₂ seitlich verschoben, wobei a₂ deutlich kleiner als eine halbe Periode des Polabstandes benachbarter Magnetpole sein sollte. Bei Drehung des Polrades 3 um seine Achse G₁ wird die Widerstandskennlinie der giant-magnetoresistiven Sensoren n-fach (pro Polradumdrehung) durchlaufen, wobei die beiden Sensoren je ein um 90° phasenverschobenes periodisches Signal liefern. Dies führt beispielsweise zu einer besseren Abtastung der durch die Polzahl des magnetischen Polrades vorgegebenen Grundauflösung, als sie mit zwei nur unter Einhaltung eines vorbestimmten Abstandes nebeneinander anordbaren Hallsensoren zu realisieren wäre. Denn die beiden GMR-Sensoren 12 und 13 können vorteilhaft in unmittelbarer Nachbarschaft nebeneinander z.B. auf einem gemeinsamen Chip angeordnet werden. Außerdem ermöglicht die gezeigte Ausführungsform vorteilhaft eine Richtungserkennung der Drehung.

Abweichend von der Positionserfassungsvorrichtung 10 nach Figur 3 sind bei der in Figur 4 gezeigten Ausführungsform einer Drehpositionserfassungsvorrichtung 15 die giant-magnetoresistiven Sensoren 16 und 17 ihrer Sensoreinrichtung 18 nicht in einer gemeinsamen Ebene angeordnet, sondern liegen in parallelen Ebenen. Der Aufbau der Mehrschichtensysteme der Sensoren kann entweder auf hybridem Wege oder durch geeignete Beschichtung und Strukturierung eines Wafers 19 entweder auf dessen gegenüberliegenden Flachseiten oder auch auf einer Seite erfolgen. Die Sensoren haben eine gemeinsame Bezugsachse H₃ in Richtung ihrer Flächennormalen. Die z.B. im Bereich der Mitten der Sensoren verlaufende Bezugsachse H₃ schließt mit der Drehachse G₁ des Polrades 3 wiederum einen Winkel von 90° ein. Aufgrund der erlaubten Abstandstoleranzen geben die Sensoren der Vorrichtung 15 ein in der Amplitude zumindest annähernd gleiches, aber um 90° phasenverschobenes Signal ab.

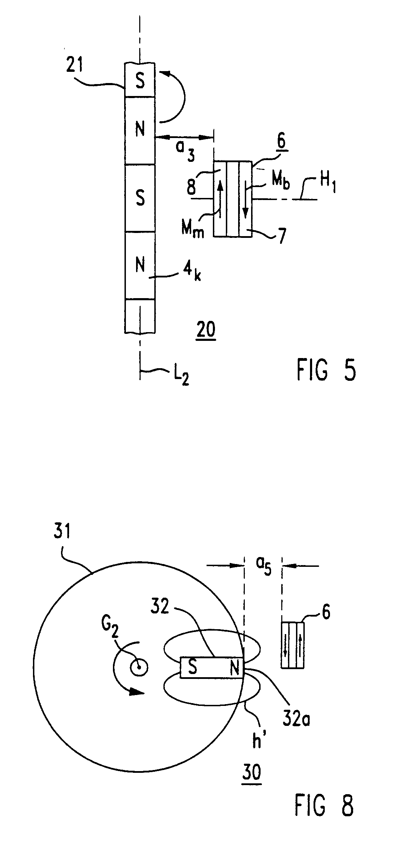

Gemäß den Figuren 1 bis 4 wurde davon ausgegangen, daß eine Bezugslinie L₁ der Magnetpole einer magnetfelderzeugenden Einrichtung eine Umfangslinie eines Polrades 3 beschreibt. Ebensogut kann jedoch die Bezugslinie auch eine Gerade bilden. Ein entsprechendes Ausführungsbeispiel einer Linearpositionserfassungsvorrichtung ist in Figur 5 veranschaulicht. Diese mit 20 bezeichnete Vorrichtung enthält als magnetfelderzeugende Einrichtung ein sich längs einer geraden Bezugslinie L₂ erstreckendes magnetisches Band 21 mit n hintereinandergereihten Magnetpolen 4ₖ (mit 1 ≤ k < n) abwechselnder Polarität. Die Bezugslinie L₂ verläuft dabei in senkrechter Richtung bezüglich der Normalen H₁ auf dem giant-magnetoresistiven Sensor 6 (z.B. nach Figur 1). Zwischen dem Mehrschichtensystem des Sensors und dem magnetischen Band 21 ist ein Abstand a₃ eingehalten. Bei Bewegung des Sensors 6 entlang einer zur Bezugslinie L₂ um den Abstand a₃ beabstandeten parallelen Linie oder des magnetischen Bandes entlang der Bezugslinie L₂ wird die Widerstandskennlinie des giant-magnetoresistiven Sensors 6 n-fach durchlaufen. Da die Richtung der Magnetisierung Mₘ der weichmagnetischen Meßschicht 8 des Sensors 6 in einem weiten Feldbereich dem einwirkenden Magnetfeld des magnetischen Bandes 21 folgt und die Widerstandsänderung des Mehrschichtensystems des Sensors nur vom Winkel der Magnetisierungen Mₘ in seiner Meßschicht und M_{b} in seinem Biasteil 7 bzw. der Biasschicht abhängt, ist das von der Sensoreinrichtung abgegebene Signal, das die Position des magnetischen Bandes 21 abbildet, vorteilhaft in einem weiten Bereich unabhängig vom Abstand a₃ zwischen dem magnetischen Band 21 und dem Sensor 6.

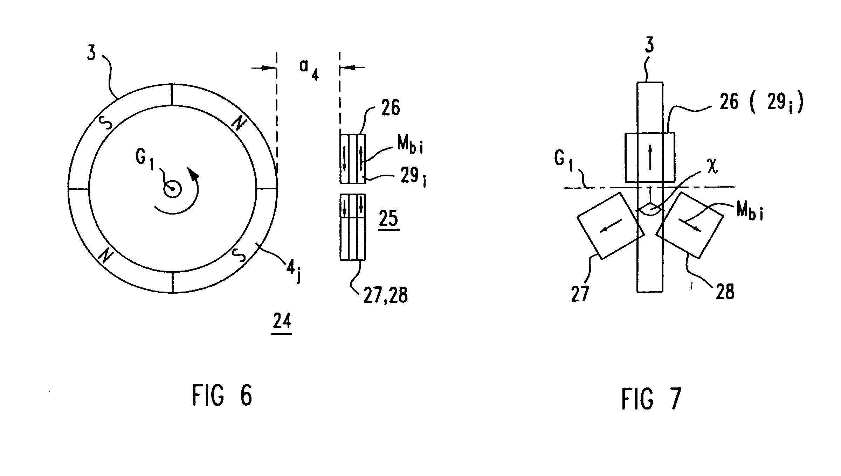

Die in den Figuren 1 bis 5 gezeigten Ausführungsformen von erfindungsgemäßen Positionserfassungsvorrichtungen sehen vor, daß die Bezugsachsen bzw. Normalen auf ihren Sensoreinrichtungen bzw. Sensoren jeweils zumindest annähernd senkrecht bezüglich der Drehachse G₁ und/oder senkrecht zu den Bezugslinien L₁ und L₂ verlaufen. Eine erfindungsgemäße Positionserfassungsvorrichtung ist jedoch nicht auf derartige Winkel zwischen den Normalen und den Bezugslinien beschränkt. Vielmehr können auch Winkel größer oder kleiner als 90°, vorzugsweise aus dem Bereich zwischen 60° und 120°, gewählt werden. Da die Richtung der Magnetisierung Mₘ der weichmagnetischen Meßschicht in einem giant-magnetoresistiven Sensor in einem weiten Feldbereich der Richtung des einwirkenden Magnetfeldes folgt und die Widerstandsänderung seines Mehrschichtensystems nur vom Winkel zwischen den Richtungen der Magnetisierungen Mₘ in der Meßschicht und M_{b} in dem Biasteil abhängt, ist das von dem Mehrschichtensystem abgegebene Signal, das z.B. die Winkellage eines magnetischen Polrades abbildet, in einem weiten Bereich unabhängig vom Winkel zwischen einer Normalen auf der Ebene der Meßschicht eines Mehrschichtensystems und der Bezugslinie des mindestens einen Magnetpols. Dies erlaubt vorteilhaft hohe Einbautoleranzen bei einer Fertigung und Montage entsprechender Systeme und bedeutet, daß verschiedene Exemplare des gleichen Systems unterschiedliche Winkel aus dem genannten Winkelbereich haben können, ohne daß sich praktisch ihre elektrische Funktionsweise ändert. Ein entsprechendes Ausführungsbeispiel ist aus den Figuren 6 und 7 ersichtlich.

Bei der in diesen Figuren gezeigten Positionserfassungsvorrichtung 24 wird statt der in den Figuren 3 und 4 dargestellten Anordnung einer Sensoreinrichtung mit zwei Sensoren nunmehr eine solche Einrichtung 25 mit mehr als zwei, beispielsweise drei in einer Ebene liegende Sensoren 26 bis 28 verwendet. Diese von dem Polrad 3 um eine Größe a₄ beabstandete Sensoren sind vorzugsweise unter einem Winkel χ= 120° ihrer in der Sensorebene liegenden Flächenachsen bzw. der Richtungen der Magnetisierungen M_{bi} ihrer Biasteile 29ᵢ (mit 1 ≤ i ≤ 3) zueinander angeordnet. Dadurch werden von jedem Sensor nur noch zwei lineare Bereiche von je 60° zu einer 360°-Detektion benötigt anstatt von je 90° gemäß der Ausführungsform nach den Figuren 3 und 4.

Figur 8 zeigt eine Ausführungsform einer Drehpositionserfassungsvorrichtung 30 mit einem Polrad 31 als magnetfelderzeugender Einrichtung, die nur einen einzigen magnetischen Doppelpol 32 aufweist. Der z.B. von einem Stabmagneten gebildete Doppelpol ist dabei so angeordnet, daß er sich in radialer Richtung bezüglich der Drehachse G₂ des Polrades 31 erstreckt. D.h., nur ein Magnetpol 32a dieses Stabmagneten ist dem giant-magnetoresistiven Sensor 6 (z.B. gemäß Figur 1) einer Sensoreinrichtung unter Einhaltung eines Abstandes a₅ zugewandt. Das von dem Stabmagneten hervorgerufene Magnetfeld ist durch Feldlinien h' angedeutet. Die gezeigte Vorrichtung 30 kann insbesondere zur Erzeugung von Trigger- oder Zählimpulsen verwendet werden.

## Patentansprüche

1. Vorrichtung (2, 10, 15, 20, 25, 30) zur berührungslosen Erfassung der Position eines Objektes bezüglich einer vorgegebenen Ausgangslage
- mit einer magnetfelderzeugenden Einrichtung (3, 21, 31), die an einer gedachten Bezugslinie (L₁, L₂) einen Magnetpol (32a) oder längs der Linie mehrere hintereinandergereihte, wechselnde Magnetfeldrichtungen erzeugende Magnetpole (4ⱼ, 4ₖ) bildet,
- mit einer Sensoreinrichtung (5, 11, 18, 25), die wenigstens einen stromdurchflossenen, einen GMR-Effekt zeigenden Sensor (6, 12, 13, 16, 17, 26-28) enthält, der ein Schichtensystem mit mindestens einer magnetisch weichen Meßschicht (8) mit einer in ihrer Schichtebene drehbaren Magnetisierungen (Mₘ) und mindestens einen magnetisch härteren Biasteil (7, 29ᵢ) mit einer zumindest weitgehend unveränderten Magnetisierung (M_{b}, M_{b1}, M_{b2}, M_{bi}) aufweist,
sowie
- mit einer starren Verbindung des Objektes mit der Sensoreinrichtung oder der magnetfelderzeugenden Einrichtung, wobei die magnetfelderzeugende Einrichtung bezüglich der Sensoreinrichtung
i) so angeordnet ist, daß die Richtung einer Normalen (H₁, H₁', H₂, H₃) auf der Ebene der Meßschicht des wenigstens einen Sensors unter einem von Null verschiedenen Winkel ϕ bezüglich der gedachten Bezugslinie (L₁, L₂) des mindestens einen Magnetpols verläuft,
und
ii) so relativ zu bewegen ist, daß dabei das Magnetfeld (h, h') des mindestens einen Magnetpols von der Meßschicht des wenigstens einen Sensors erfaßt wird und daß dabei ein der Zahl (n) der erfaßten Magnetpole entsprechend vielfaches Durchlaufen der Sensorkennlinie oder eines Teils derselben bewirkt wird,
**gekennzeichnet durch** eine Anordnung der magnetfelderzeugenden Einrichtung (3, 21, 31) bezüglich der Sensoreinrichtung (5, 11, 18, 25) derart, daß der mindestens eine Magnetpol (4ⱼ, 4ₖ) der magnetfelderzeugenden Einrichtung mit seiner Polfläche der Meßschicht (8) des wenigstens einen Sensors (6, 12, 13, 16, 17, 26-28) zugewandt ist.

2. Vorrichtung nach Anspruch 1, **dadurch gekennzeichnet, daß** die Bezugslinie (L₂) zumindest annähernd eine Gerade ist.

3. Vorrichtung nach Anspruch 1, **dadurch gekennzeichnet, daß** die Bezugslinie (L₁) zumindest annähernd die Umfangslinie eines Polrades (3, 31) ist.

4. Vorrichtung nach einem der Ansprüche 1 bis 3, **dadurch gekennzeichnet, daß** die Sensoreinrichtung (11, 18, 25) mehrere elektrisch miteinander verschaltete Sensoren (12, 13; 16, 17; 26-28) umfaßt.

5. Vorrichtung nach Anspruch 4, **dadurch gekennzeichnet, daß** zwei Sensoren (11, 12) vorgesehen sind, deren Biasteile ihrer Schichtensysteme Magnetisierungsrichtungen (M_{b1}, M_{b2}) aufweisen, die zumindest weitgehend rechtwinklig zueinander verlaufen.

6. Vorrichtung nach Anspruch 4, **dadurch gekennzeichnet, daß** drei Sensoren (26-28) vorgesehen sind, deren Biasteile (29ᵢ) ihrer Schichtensysteme Magnetisierungsrichtungen (M_{bi}) aufweisen, die untereinander jeweils zumindest annähernd einen Winkel von 120° einschließen.

7. Vorrichtung nach einem der Ansprüche 4 bis 6, **dadurch gekennzeichnet, daß** die Sensoren (12, 13; 26-28) in einer gemeinsamen Ebene liegen.

8. Vorrichtung nach einem der Ansprüche 4 bis 6, **dadurch gekennzeichnet, daß** die Sensoren (16, 17) in parallelen Ebenen liegen.

9. Verwendung der Vorrichtung nach einem der Ansprüche 1 bis 8 zumindest als Teil eines kontaktlosen Potentiometers.

## Claims

1. Device (2, 10, 15, 20, 25, 30) for contactless sensing of the position of an object with respect to a predetermined starting position, having
- a magnetic field-generating instrument (3, 21, 31), which forms a magnetic pole (32a) on an imaginary reference line (L₁, L₂) or forms, along the line, a plurality of successively arranged magnetic poles (4ⱼ, 4ₖ) which generate alternating magnetic-field directions,
- a sensor instrument (5, 11, 18, 25) containing at least one current-carrying sensor (12, 13, 16, 17, 26-28), which exhibits a GMR effect and has a layer system with at least one magnetically soft measurement layer (8) whose magnetization (Mₘ) can be rotated in its layer plane and at least one magnetically harder bias part (7, 29ᵢ) whose magnetization (M_{b}, M_{b1}, M_{b2}, M_{bi}) is at least substantially invariant,
and
- a rigid connection of the object to the sensor instrument or to the magnetic field-generating instrument,
the magnetic field-generating instrument being
i) arranged, with respect to the sensor instrument, in such a way that the direction of a normal (H₁, H₁', H₂, H₃) to the plane of the measurement layer of the at least one sensor extends at a non-zero angle ϕ with respect to the imaginary reference line (L₁, L₂) of the at least one magnetic pole,
and
ii) movable, relative to the sensor instrument, in such a way that the magnetic field (h, h') of the at least one magnetic pole is thereby sensed by the measurement layer of the at least one sensor and the sensor characteristic curve, or a part thereof, is thereby passed through repeatedly, the number of repetitions corresponding to the number (n) of magnetic poles sensed,
**characterised by** an arrangement of the magnetic field-generating instrument (3, 21, 31), with respect to the sensor instrument (5, 11, 18, 25), such that the at least one magnetic pole (4ⱼ, 4ₖ) of the magnetic field-generating instrument has its pole surface facing the measurement layer (8) of the at least one sensor (12, 13, 16, 17, 26-28).

2. Device according to Claim 1, **characterised in that** the reference line (L₂) is at least approximately a straight line.

3. Device according to Claim 1, **characterised in that** the reference line (L₁) is at least approximately the circumferential line of a magnet wheel (3, 31).

4. Device according to one of Claims 1 to 3, **characterised in that** the sensor instrument (11, 18, 25) comprises a plurality of sensors (12, 13; 16, 17; 26-28) which are electrically interconnected.

5. Device according to Claim 4, **characterised in that** two sensors (11, 12) are provided, the bias parts of whose layer systems have magnetization directions (M_{b1}, M_{b2}) which extend-at least substantially at right angles to one another.

6. Device according to Claim 4, **characterised in that** three sensors (26-28) are provided, the bias parts (29ᵢ) of whose layer systems have magnetization directions (M_{bi}) which respectively meet one another at least substantially at an angle of 120°.

7. Device according to one of Claims 4 to 6, **characterised in that** the sensors (12, 13; 26-28) lie in a common plane.

8. Device according to one of Claims 4 to 6, **characterised in that** the sensors (16, 17) lie in parallel planes.

9. Use of the device according to one of Claims 1 to 8 as at least part of a contactless potentiometer.

## Revendications

1. Dispositif (2, 10, 15, 20, 25, 30) de détection sans contact de la position d'un objet par rapport à une position de départ donnée à l'avance
- comprenant un dispositif (3, 21, 31) de production de champ magnétique, qui forment sur une ligne (L₁, L₂) de référence imaginaire un pôle (32a) magnétique ou le long de la ligne plusieurs pôles (4ⱼ, 4ₖ) magnétiques se succédant et produisant des directions alternées de champs magnétiques,
- comprenant un dispositif (5, 11, 18, 25) à capteur, qui comprend au moins un capteur (6, 12, 13, 16, 17, 26 à 28) dans lequel passe du courant qui présente un effet MRG et qui a un système de couches ayant au moins une couche (8) de mesure douce magnétiquement ayant une magnétisation (Mₘ) pouvant tourner dans son plan de couche et au moins une partie (7, 29ᵢ) de polarisation magnétiquement plus dure, ayant une magnétisation (M_{b}, M_{b1}, M_{b2}, M_{bi}) qui au moins sensiblement ne se modifie pas, ainsi que
- comprenant une liaison rigide de l'objet au dispositif à capteur ou au dispositif produisant le champ magnétique, le dispositif produisant le champ magnétique étant, par rapport au dispositif à capteur
i) disposé de façon que la direction d'une normale (H₁, H_{1'}, H₂, H₃) au plan de la couche de mesure du au moins un capteur s'étende en faisant un angle ϕ différent de zéro avec la ligne (L₁, L₂) imaginaire de référence du au moins un pôle magnétique et
ii) déplacé relativement de façon que le champ (h, h') magnétique du au moins un pôle magnétique soit détecté par la couche de mesure du au moins un capteur et qu'ainsi l'un du nombre (n) des pôles magnétiques détectés soit mis en oeuvre conformément au parcours plusieurs fois de la courbe caractéristique ou d'une partie de celle-ci,
**caractérisé par** un agencement du dispositif (3, 21, 31) de production du champ magnétique par rapport au dispositif (5, 11, 18, 25) à capteur tel que le au moins un pôle (4ⱼ, 4ₖ) magnétique du dispositif produisant un champ magnétique soit tourné par sa surface polaire vers la couche (8) de mesure du au moins un capteur (6, 12, 13, 16, 17, 26 à 28).

2. Dispositif suivant la revendication 1, **caractérisé en ce que** la ligne (L₂) de référence est au moins approximativement une droite.

3. Dispositif suivant la revendication 1, **caractérisé en ce que** la ligne (L₁) de référence est au moins approximativement la ligne de pourtour d'une roue (3, 21) polaire.

4. Dispositif suivant l'une des revendications 1 à 3, **caractérisé en ce que** le dispositif (11, 18, 25) à capteur comprend plusieurs capteurs (12, 13; 16, 17 ; 26 à 28) reliés électriquement entre eux.

5. Dispositif suivant la revendication 4, **caractérisé en ce qu'**il est prévu deux capteurs (11, 12) dont les parties de polarisation de leur système de couches ont des directions (M_{b1}, M_{b2}) de polarisation qui s'étendent au moins dans une grande mesure perpendiculairement entre elles.

6. Dispositif suivant la revendication 4, **caractérisé en ce qu'**il est prévu trois capteurs (26 à 28) dont les parties (29ᵢ) de polarisation de leur système de couches ont des directions (M_{bi}) de magnétisation qui font entre elles respectivement un angle au moins approximativement de 120°.

7. Dispositif suivant l'une des revendications 4 à 6, **caractérisé en ce que** les capteurs (12, 13 ; 26 à 28) sont dans un plan commun.

8. Dispositif suivant l'une des revendications 4 à 6, **caractérisé en ce que** les capteurs (16, 17) sont dans des plans parallèles.

9. Utilisation du dispositif suivant l'une des revendications 1 à 8, au moins comme partie d'un potentiomètre sans contact.
